# EUROPEAN PATENT APPLICATION

(11) **EP 1 416 003 A1**
(43) Date of publication of application: **06.05.2004**
(21) Application number: 02755859.2
(22) Date of filing: 06.08.2002
(51) Int. Cl.: C08F 299/02, C08F 290/06, C08G 59/17, C08G 59/42, C09D 11/10, G03F 7/027, G03F 7/038, H05K 3/28, H05K 3/46

(54) **RESIN COMPOSITION, COMPOSITION FOR SOLDER RESIST, AND CURED ARTICLE OBTAINED THEREFROM**

(30) Priority: 07.08.2001 JP 2001239412
(71) Applicant: Nippon Kayaku Kabushiki Kaisha, Tokyo 102-8172 (JP)
(72) Inventor: KOYANAGI, Hiroo, Itabashi-ku, Tokyo 175-0092 (JP); OZAKI, Toru, Kitakatsushika-gun, Saitama 340-0203 (JP); YOKOSHIMA, Minoru, Toride-shi, Ibaraki 302-0015 (JP)
(74) Representative: Prop, Gerrit
(86) International application number: PCT/JP2002/008025
(87) International publication number: WO 2003/014177

(57) **Abstract**

A resin composition which is excellent in photosensitively and developability, gives a cured article excellent in flexibility, soldering heat resistance, resistance to thermal deterioration, and resistance to electroless gold plating, and is suitable especially for use in forming solder resists and interlayer dielectrics. Theresincompositionischaracterized by containing an oligomer (A) obtained by reacting the following ingredients (a) to (d) : an epoxy resin having at least two epoxy groups per molecule, a compound having two hydroxy groups and one carboxy group per molecule, a carboxy group per molecule, a carboxylated rubbery polymer, and a monobasic acid having an unsatuated group.

## Description

### TECHNICAL FIELD

The present invention relates to a resin composition and a cured article thereof, which are applicable to various coating materials, surface treatment materials, materials for use in waveguide, laminated plates, bonding agents, stickers, printing ink, sealing agents, color resists (for use in LCDs and CCDs) and liquid resist ink, and are particularly useful for compositions for use in printed circuit boards. More specifically, the present invention concerns a resin composition which is suitablyusedas solder resist foruse in flexible printed circuit boards, plating resist and multi-layer printed circuit board use inter-layer electric insulating materials, is excellent in developing property, and gives a cured article that forms a coat film superior in adhesion, flexibility (bending property), soldering heat resistance, chemical resistance, resistance to electroless gold plating, and also concerns its cured article.

### BACKGROUND ART

In a soldering process that is carried out so as to protect a wiring (circuit) pattern formed on a substrate through a screen printing method and the like from external environment and also to surface-assemble an electric part on a printed circuit board, conventionally, a protective layer, referred to as a cover coat or a solder mask, is applied on the printed circuit board so as to prevent the solder from adhering to unnecessary portions.

Conventionally, with respect to solder resist ink to be used for such a purpose, a multi-functional epoxy resin-based ink has been mainly used; however, the problem with this ink is that the resulting cured film is inferior in its flexibility although it provides superior heat resistance. Therefore, the solder resist ink of this type is limited in its use to a rigid plate that does not require any flexibility (bending property) in the cured film, and it is difficult to apply this to flexible printed circuit boards (FPC) that have been widely used in recent years.

Under these circumstances, recently, various resist inks having flexibility have been proposed. For example, Japanese Patent Application Laid-open No. 2-269166 has disclosed a heat-curing type solder resist inkmade frompolyparabanic acid, epoxy resin and a polar solvent, JP-A No. 6-41485 has disclosed a solder resist ink of a heat-drying type that uses polyparabanic acid and phenoxy resin as its essential components. However, these solder resists are formed as a resist pattern by using a screen printing process, with the result that there is a limitation in the line width and the like of the screen; thus, these fail to provide a fine image forming process that meets the current demands for high density. For this reason, in recent years, those of a photographic developing type, such as those disclosed in JP-A No. 2-172749, JP-A No. 2-173750 and JP-A No. 173751, have been proposed; however, these have not achieved sufficient flexibility.

The objective of the present invention is to provide a resin composition and its cured article, and the resin composition, which is formed by using a specific oligomer (A), is superior in curability (photosensitivity) , even when the used amount of a polymerization initiator is smaller than the conventional used amount, is excellent in developability even when the acid value (mgKOH/g) thereof is smaller than the conventional acid value, and provides a cured film, obtained by thermally curing the resin composition in a post curing process, which forms a coat film that is superior in flexibility, and excellent in soldering heat resistance, resistance to thermal deterioration, resistance to electroless gold plating, acid resistance and water resistance, and the resin composition is also suitably applied to an organic solvent or alkali developing type ink, in particular, a resist ink for use in flexible printed circuit boards.

### DISCLOSURE OF THE INVENTION

In order to solve the above-mentionedproblems, the inventors of the present invention have found that an application of a resin composition containing a specific oligomer (A) makes it possible to achieve the above-mentioned objectives, and devised the present invention.

In other words, the present invention relates to a resin composition which contains:
(1) an oligomer (A) obtained by allowing the following components (a) to (d) to react with one another:
   (a) an epoxy resin having at least two epoxy groups per molecule;
   (b) a compound having two hydroxyl groups and one carboxyl group per molecule;
   (c) a carboxylated rubbery polymer; and
   (d) a monobasic acid having an unsaturated group.
(2) an oligomer (B) obtained by allowing the following compounds (a) to (e) to react with one another:
   (a) an epoxy resin having at least two epoxy groups per molecule;
   (b) a compound having two hydroxyl groups and one carboxyl group per molecule;
   (c) a carboxylated rubbery polymer;
   (d) a monobasic acid having an unsaturated group; and
   (e) a multibasic acid anhydride.
(3) the resin composition described in the above-mentioned (1) or (2) in which the oligomer (A) has a weight-average molecular weight in a range of 1000 to 100,000.
(4) the resin composition described in any one of the above-mentioned (1) to (3) in which the oligomer (A) has an acid value in a range of 1 to 300 mgKOH/g.
(5) the resin composition described in any one of the above-mentioned (1) to (4) in which the epoxy resin (a) having at least two epoxy groups per molecule is represented by the following formula (1): 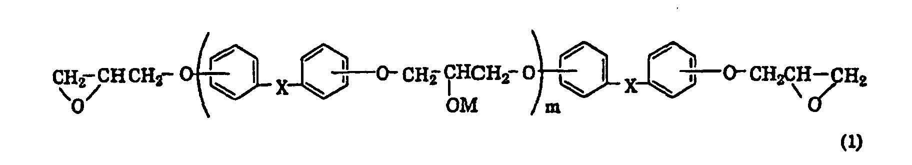 (in formula (1), X is -CH₂- or -C(CH₃)₂-, m is an integer of 1 or more, and M is a hydrogen atom or a group represented by the following formula (G): 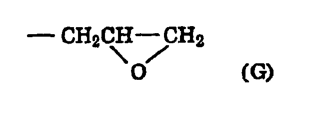 here, in the case when m is 1, M is represented by formula (G) , and in the case when m is larger than 1, at least one of M is represented by formula (G) with the rest thereof being hydrogen atoms.)
(6) the resin composition described in the above-mentioned (5) in which in formula (1), the rate of M being represented by formula (G) is in a range of 70 to 90 mole%,
(7) the resin composition described in any one of the above-mentioned (1) to (6), in which the compound (b) having two hydroxyl groups and one carboxyl group per molecule is a dimethylolated compound of carboxylic acid having 2 to 6 carbon atoms,
(8) the resin composition described in any one of the above-mentioned (1) to (7), in which the monobasic acid having an unsaturated group (d) is one kind or two or more kinds of compounds selected from the group consisting of (metha) acrylic acids and monobasic acids containing a maleimide group,
(9) the resin composition described in the above-mentioned (2) inwhichthemultibasicacidanhydride (e) is aphthalicanhydride derivative,
(10) the resin composition described in any one of the above-mentioned (1) to (9), which contains a photo-polymerization initiator (C),
(11) the resin composition described in any one of the above-mentioned (1) to (11), which contains a heat curing component (D),
(12) the resin composition described in the above-mentioned (11) in which the heat curing component (D) is an epoxy resin,
(13) the resin composition described in the above-mentioned (12), which contains a 1,4-dihydropyridine derivative as a curing accelerator agent for the epoxy resin,
(14) the resin composition described in any one of the above-mentioned (1) to (13), which contains a diluent (B),
(15) a composition which contains the resin composition described in the above-mentioned (14), and is used for a solder resist or an interlayer insulating layer for use in a printed circuit board,
(16) a cured article of the composition described in any one of the above-mentioned (1) to (15),
(17) a product having a layer of the cured article described in the above-mentioned (16), and
(18) the product described in the above-mentioned (17), which is a printed circuit board.

### BEST MODE FOR CARRYING OUT THE INVENTION

The following descriptionwill discuss the present invention in detail. Here, in the following description, "part" and "%" represent "part by mass" and "% by mass", respectively, unless otherwise defined.

The resin composition of the present invention contains an oligomer (A), and the molecular weight of the oligomer (A) to be used is preferably set in a range of 1000 to 100,000 in the weight-averagemolecularweight, anditsacidvalueispreferably set in a range of 1 to 300 mg KOH/g.

The oligomer (A) to be used in the present invention is a reaction product obtained by allowing the following components to react with one another: an epoxy resin (a) having at least two epoxy groups per molecule, a compound (b) having two hydroxyl groups and one carboxyl group per molecule, a carboxylated rubbery polymer (c), a monobasic acid (d) containing an unsaturated group, and a multibasic acid anhydride (e) that is an optional component.

With respect to the epoxy resin (a) having at least two epoxy groups permolecule to be used, specific examples thereof include novolak-type epoxy resins (for example, those obtained by allowing each of novolak compounds, obtained by allowing each of phenols such as phenol, cresol, halogenated phenol and alkyl phenol to react with formaldehyde in the presence of an acidic catalyst, to react with epichlorohydrin and/or methyl epichlorohydrin. With respect to the commercial products, examples thereof include EOCN-103, EOCN-140S, EOCN-1020, EOCN-1027, EPPN-201 and BREN-S made by Nippon Kayaku Co., Ltd.; DEN-431 and DEN-439 made by the Dow Chemical Company; and N-730, N-770, N-865, N-665, N-673 and VH-4150 made by Dainippon Ink and Chemicals, Incorporated, etc.),bisphenol-type epoxy resins (for example, those obtained by allowing each of bisphenols such as bisphenol A, bisphenol F, bisphenol S and tetrabrombisphenol A to react with epichlorohydrin and/or methyl epichlorohydrin, and those epoxyresins representedbythe above-mentioned formula (1) that are obtained by allowing glycidyl ether of bisphenol A and bisphenol F, a condensate of the each of above-mentioned bisphenols and epichlorohydrin and/or methyl epichlorohydrin to react with one another. With respect to the commercial products, examples thereof include Epicoat 1004 andEpicoat 1002 made by Yuka Shell K.K.; and DER-330 and DER-337 made by the DowChemicalCompany) , trisphenolmethane-type epoxy resins (for example, those obtained by allowing triphenol methane, triscresol methane or the like to react with epichlorohydrin and/or methyl epichlorohydrin. With respect to the commercial products, examples thereof include EPPN-501, EPPN-502 and the like), tris(2,3-epoxypropyl)isocyanurate, biphenyl diglycidyl ether and other materials such as epoxy resins containing an alicyclic amino group like Celloxide 2021 made by Daicel Chemical Industries, Ltd.; Epomic VG-3101 made by Mitsui Petrochemical Industries, Ltd.; TETRAD-X and TETRAD-C made by Mitsubishi Gas Chemical Company, Inc.; and EPB-13, EPB-27, and the like made by Nippon Soda Co., Ltd., copolymer-type epoxy resins (for example, a copolymer of diglycidyl methacrylate and styrene, and a copolymer of diglycidyl methacrylate, styrene and methylmethacrylate, that is, CP-50M and CP-50S, made by Nippon Oil & Fats Co., Ltd., or a copolymer of glycidyl methacrylate and cyclohexyl maleimide), or other epoxy resins and the like having a special structure. Among these, in particular, preferable examples are epoxy resins and the like represented by the above-mentioned formula (1). In particular, in formula (1), those resins in which the rate of M being a glycidyl group is set to 70 to 90 mole% are preferably used.

Next, with respect to the compound (b) having two hydroxyl groups and one carboxyl group per molecule, examples thereof include dimethylolated compounds of carboxylic acid, and specific examples thereof include dimethylolated compounds of carboxylic acid having carbon atoms of 2 to 6, preferably, 2 to 4, such as dimethylol propionic acid, dimethylol acetic acid, dimethylol butyric acid, dimethylol valeric acid and dimethylol caproic acid.

Moreover, with respect to the carboxylated rubbery polymer (c), although its structure is not particularly limited, examples thereof include rubbery polymers which have carboxylic groups added to the two molecular terminals of each of the following copolymers, or to the two molecular terminals of a straight-chain polymer, and examples of the copolymers are: a copolymer between a conjugated diene-based vinyl monomer and ethylenic unsaturated mono-basic acid, such as butadiene-acrylic acid copolymer; a copolymer of a conjugated diene-based vinyl monomer, ethylenic unsaturated mono-basic acid and another vinyl monomer, such as butadiene-acrylonitrile-acrylic acid copolymer; a carboxylic acid suspended-type conjugate diene-based vinyl copolymer, such as a maleated polybutadiene, typically represented by the following formula 1 or formula 2. 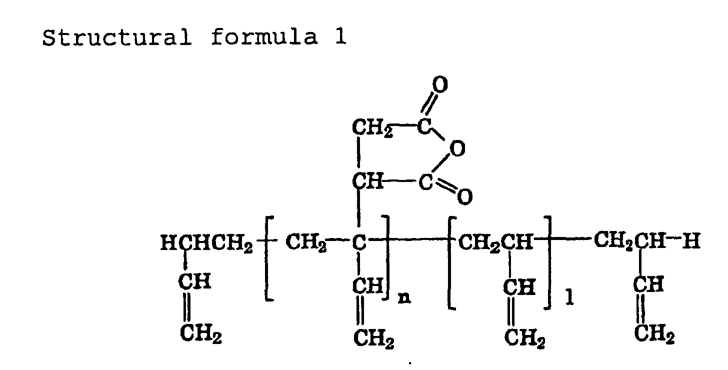 (in this formula, each of n and 1 represents an average unit number of repetitions, and is an integer of 1 or more.) 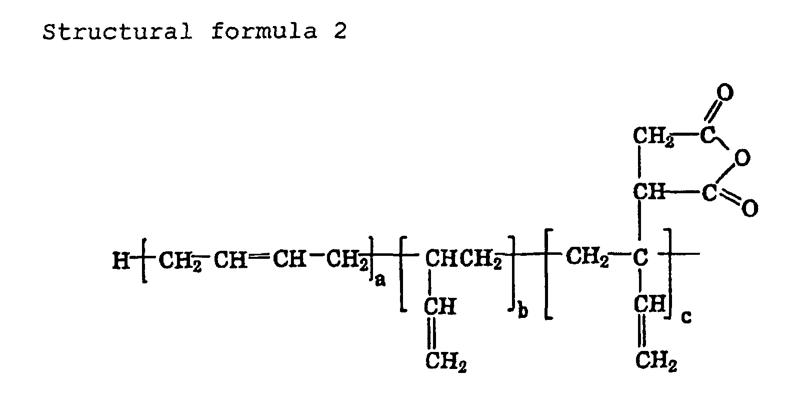 (in this formula, each of a, b and c represents an average unit number of repetitions, and is an integer of 1 or more.)

With respect to the above-mentioned rubbery polymer having carboxylic groups added to the two molecular terminals of the straight-chain polymer, examples thereof include a diene-based vinyl polymer having carboxylic groups added to the two molecular terminals of polybutadiene dicarboxylic acid represented by, for example, the following structural formula 3; a polymer with carboxyl groups added to the two molecular terminals thereof, which is a copolymer between a conjugated diene-based vinyl monomer and an ethylenic unsaturated mono-basic acid, such as a polymer having carboxylic groups added to the two molecular terminals of a butadiene-acrylonitrile copolymer, represented by the following structural formula 4 (for example, HYCAR CTBN1300 × 13 [made by B. F. Good rich chemical Co., Ltd.] having a molecular weight of 3500, 27% of bonded acrylonitrile, 1.9 carboxyl groups/molecule) ; and a half ester between a conjugated diene-based vinyl polymer and an anhydride, such as a copolymer of polybutadiene glycol and maleic anhydride represented by the following structural formula 5. 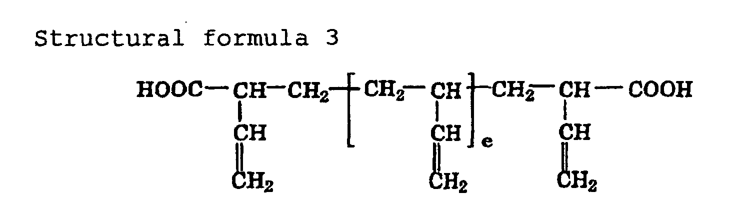 (in this formula, e represents an average unit number of repetitions, and is an integer of 1 or more.) 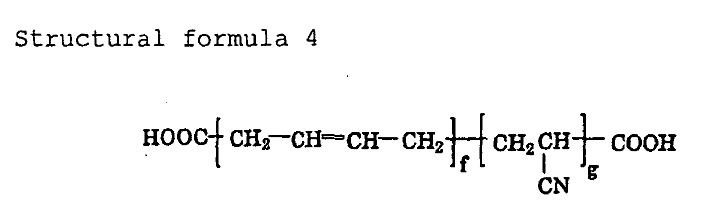 (in this formula, each of f and g represents an average unit number of repetitions, and is an integer of 1 or more.) 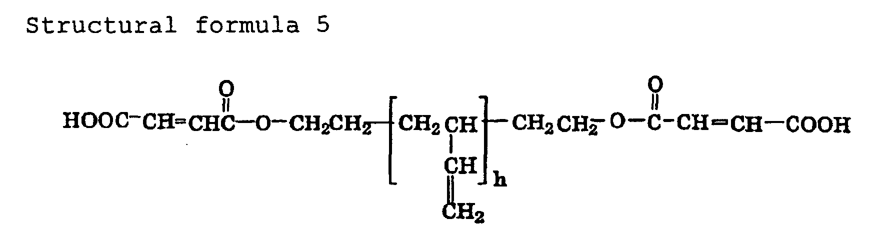 (in this formula, h represents an average unit number of repetitions, and is an integer of 1 or more.)

Here, with respect to the conjugated diene-based vinyl polymer to be used in the above-mentioned carboxylated rubbery polymer, in place of the above-exemplified polymer derived from butadiene, polymers derived from isoprene, chloroprene and the like may be used. Moreover, each of these may be copolymerized with a conjugated diene-based vinyl monomer. With respect to the ethylenic unsaturated monobasic acid, examples thereof include (metha)acrylic acid, crotonic acid, cinnamic acid, acrylic acid dimer, monomethyl maleate, monopropyl maleate, monobutyl maleate, mono (2-ethylhexyl)maleate and sorbic acid, and among these, (metha) acrylic acid is preferably used. With respect to the other vinyl monomer, acrylic acid, methacrylic acid, acrylonitrile, styrene, vinyl toluene and the like may be used.

Moreover, with respect to the number of carboxyl groups in the rubbery polymer, although not particularly limited, the number of carboxyl groups is set in a range of 1 to 5, preferably, 1.5 to 3, in average per molecule.

Furthermore, with respect to the specific examples of the monobasic acid having an unsaturated group (d) , examples thereof include unsaturatedmonocarboxylic acid, such as (metha) acrylic acid, acrylic acid dimer, β-styrylacrylic acid, β-furfuryl acrylic acid, crotonic acid, α-cyanocinnamic acid and cinnamic acid. Examples thereof further include a reaction product between a saturated or unsaturated dibasic anhydride and a (metha)acrylate having one hydroxyl group per molecule, a reaction product between a saturated or unsaturated dibasic acid and a monoglycidyl compound containing an unsaturated group, and a half ester that is a reaction product between a saturated or unsaturated dibasic acid and a monoglycidyl compound containing an unsaturated group, and these can be obtained by allowing the former and the latter to react with each other on the equivalent molar basis. Here, with respect to the saturated or unsaturated dibasic acid anhydride, examples thereof include succinic anhydride, maleic anhydride, phthalic anhydride, tetrahydrophthalic anhydride, hexahydrophthalic anhydride, methylhexahydrophthalic anhydride, methyltetrahydrophthalic anhydride, itaconic anhydride and methyl endo methylene tetrahydrophthalic anhydride. Moreover, with respect to the (metha)acrylates, examples thereof include (metha)acrylates having one hydroxyl group per molecule, such as hydroxy ethyl(metha)acrylate, hydroxy propyl(metha)acrylate, hydroxy butyl (metha) acrylate, polyethylene glycolmono (metha) acrylate, glycerin di(metha)acrylate, trimethylol propane di(metha)acrylate, pentaerythritol tri(metha)acrylate, dipentaerythritol penta (metha) acrylate and (metha) acrylate of phenyl glycidyl ether. Moreover, with respect to the saturated or unsaturated dibasic acids, examples thereof include: succinic acid, maleic acid, adipic acid, phthalic acid, isophthalic acid, tetrahydrophthalic acid, hexahydrophthalic acid, itaconic acid and fumaric acid. With respect to the monoglycidyl compound containing a unsaturated group, examples thereof include the following glycidyl (metha)acrylates:

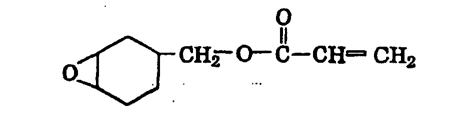

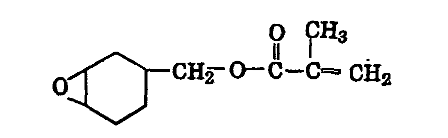

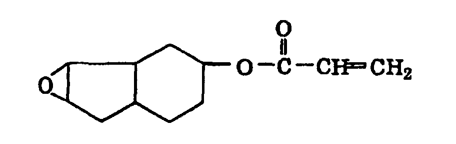

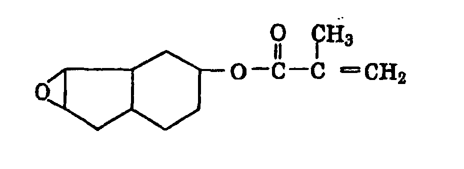

Furthermore, examples of the monobasic acid (d) containing an unsaturated group other than those described above, include monobasic acid containing a maleimide group. With respect to the monobasic acid containing a maleimide group, as indicated by the following formula, the first example is a compound (d-1) that is synthesized from maleic anhydride and primary aminocarboxylic acid by using a known technique [see "Journal of Medical Chemistry" Vol. 18, pages 1004-1010 (1975) written by D.H. Rich et al.], and the second example is a half ester compound (d-2) between a maleimide compound ([1]) and a compound ([2]) having one acid anhydride group per molecule.

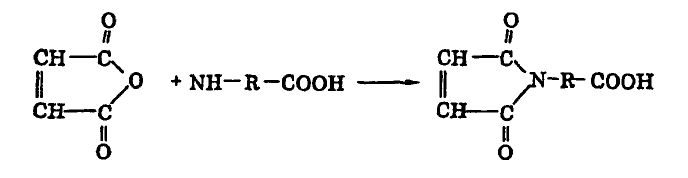

With respect to the above-mentioned primary aminocarboxylic acid, examples thereof include: asparagine, alanine, β-alanine, arginine, isoleucine, glycine, glutamine, tryptophan, threonine, valine, phenyl alanine, homophenyl alanine, α-methylphenyl alanine, lysine, leucine, cycloleucine, 3-aminopropionic acid, α-aminobutyric acid, 4-aminobutyric acid, aminovaleric acid, 6-aminocaproic acid, 7-aminoheptanic acid, 2-aminocaprylic acid, 3-aminocaprylic acid, 6-aminocaprylic acid, 8-aminocaprylic acid, 9-aminononane acid, 2-aminocapric acid, 9-aminocapric acid, 15-aminopentadecanoic acid, 2-aminopalmitic acid and 16-aminopalmitic acid; however, it is not intended to be limited by these.

With respect to the maleimide compound containing a hydroxyl group ([1]), for example, a compound that is synthesized from maleimide and formaldehyde, as indicatedbythe following formula, is used: 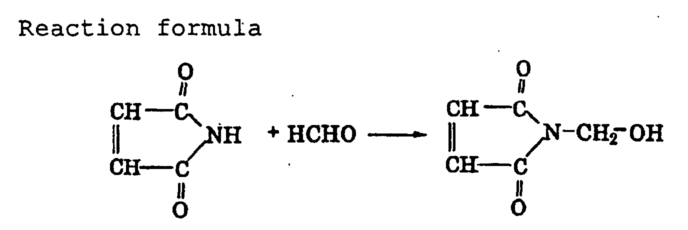 Alternatively, a compound that is synthesized from maleic anhydride andprimary aminoalcohol, as indicatedby the following formula, by using a known technique (for example, see the specification of U.S. Patent No. 2526517, JP-ANo. 2-268155 and the like) is proposed; and these compounds contain one maleimide group and one hydroxyl group per molecule.

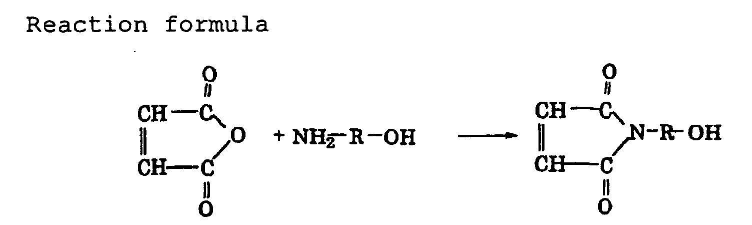

With respect to the above-mentioned primary aminoalcohol, examples thereof include: 2-aminoethanol, 1-amino-2-propanol, 3-amino-1-propanol, 2-amino-2-methyl-1-propanol, 2-amino-3-phenyl-1-propanol, 4-amino-1-butanol, 2-amino-1-butanol, 2-amino-3-methyl-1-butanol, 2-amino-4-methylthio-1-butanol, 2-amino-1-pentanol, (1-aminocyclopentane) methanol, 6-amino-1-hexanol, 7-amino-1-heptanol, and 2-(2-aminoethoxy)ethanol; however, it is not intended to be limited by these.

With respect to the above-mentioned compound ([2]) having one acid anhydride group per molecule, examples thereof include maleic anhydride, succinic anhydride, phthalic anhydride, hexahydrophthalic anhydride and tetrahydrophthalic anhydride and methyl-hexahydrophthalic anhydride.

The above-mentionedhalf ester compound (d-2) canbe obtained by allowing one chemical equivalent of hydroxyl group in the above-mentioned maleimide compound containing a hydroxyl group ([1]) and about one chemical equivalent of anhydride group in the compound ([2]) having one acid anhydride group per molecule to react with each other. The reaction temperature is preferably set in a range of 60 to 100°C, and the reaction time is preferably set in a range of 1 to 10 hours. Upon reaction, an organic solvent may be used on demand.

Preferable examples of the monobasic acid (d) containing an unsaturated group include acrylic acid and maleimide caproic acid.

Moreover, with respect to the multibasic acid anhydride (e) serving as an optional component, examples thereof include phthalic anhydride derivatives and the like, such as maleic anhydride, succinic anhydride, itaconic anhydride, dodecylsuccinic anhydride, tetrahydrophthalic anhydride, hexahydrophthalic anhydride, 3-methyltetrahydrophthalic anhydride, 4-methyltetrahydrophthalic anhydride and phthalic anhydride.

With respect to the oligomer (A) , the first specific example isoligomer (A-[1]) that is obtained by allowing the (a) component, (b) component, (c) component and (d) component to react with one another, and the second specific example is oligomer (A-[2]) that is obtained by allowing the (a) component, (b) component, (c) component and (d) component to react with one another, and by allowing the (e) component to react therewith.

With respect to the reaction rates of the respective components, with one equivalent of epoxy group in the (a) component are preferably allowed to react 0.3 to 1.1 equivalents of carboxylic group, more preferably, 0.9 to 1.05 equivalents thereof, in the total amount of the components (b) + (c) + (d). Supposing that the total amount of the carboxylic group in the (b) + (c) + (d) components is one equivalent, the used amounts of the respective components are preferably set so that the (b) component has 0.05 to 0.5 equivalents, preferably, 0.1 to 0.3 equivalents, the (c) component has 0.05 to 0.3 equivalents, preferably, 0.01 to 0.2 equivalents and the (d) component has 0.2 to 0.945 equivalents, preferably, 0.5 to 0.89 equivalents.

With respect to the (e) component, 0 to 1 equivalent thereof is preferably allowed to react with one equivalent of hydroxyl group in the reaction product of the (a), (b), (c) and (d) components.

With respect to the oligomer-forming reaction, the following materials are preferably used: non-solvents or solvents, for example, ketones such as acetone, ethylmethyl ketone and cyclohexanone; aromatic hydrocarbons such as benzene, toluene, xylene and tetramethyl benzene; glycol ethers such as ethylene glycol dimethyl ether, ethylene glycol diethyl ether, dipropylene glycol dimethyl ether, dipropylene glycol diethyl ether and triethylene glycol dimethyl ether; esters such as ethyl acetate, butyl acetate, methyl cerosolve acetate, ethyl cerosolve acetate, butyl cerosolve acetate, carbitol acetate, propylene glycol monomethyl ether acetate, dialkyl glutaric acid, dialkyl succinic acid and dialkyl adipic acid; cyclic esters such as γ-butyl lactone; and petroleum solvents such as petroleum ethers, petroleum naphtha and solvent naphtha.

Upon oligomer-forming reaction, a catalyst is preferably used so as to accelerate the reaction, and the used amount of the catalyst is set to 0.1 to 10% with respect to the reaction product. Specific examples of the catalyst include: triethyl amine, benzyldimethyl amine triethyl ammonium chloride, benzyltrimethyl ammonium bromide, benzyltrimethyl ammonium iodide, triphenyl phosphine, triphenyl stibine, chromium octanoate and zirconium octanoate.

Moreover, during the reaction, a polymerization inhibitor may be used so as to prevent polymerization. Specific examples of the polymerization inhibitor include P-methoxy phenol, hydroquinone, methyl hydroquinone and phenyl thiazine. The used amount of the polymerization inhibitor is set to 0.05 to 3% with respect to the reaction product.

The reaction temperature is preferably set to 70 to 120°C, and the reaction time is preferably set to 5 to 40 hours.

The resin composition of the present invention may further contain a diluent (B). Specific examples of the diluent (B) include the above-mentioned solvents, organic solvents (B-1), for example, alcohols such as butanol, octyl alcohol, ethylene glycol, glycerin, diethylene glycol monomethyl (or monoethyl) ether, triethylene glycol monomethyl (or monoethyl) ether and tetraethylene glycol monomethyl (or monoethyl) ether, and reactive diluents (B-2) such as carbitol (metha)acrylate, phenoxyethyl (metha) acrylate, acryloylmorpholine, trimethylol propane tri(metha)acrylate, pentaerythritol tri(metha)acrylate, pentaerythritol tetra(metha)acrylate and dipentaerythritol penta and hexa(metha)acrylate.

The amounts of (A) and (B) components contained in the resin composition of the present invention is preferably set to 10 to 90% in the total amount of (A) + (B) in the composition, more preferably, 20 to 80%, and with respect to the rates of use of (A) and (B), the rate of (A) is preferably set to 10 to 90%, and the rate of (B) is preferably set to 10 to 90%, and the mass rate of (B)/(A) is preferably set to 5 to 15%.

The resin composition of the present invention may further contain a photopolymerization initiator (C). With respect to the photopolymerization initiator (C) , examples thereof include benzoins such as benzoin, benzoin methyl ether, benzoin ethyl ether, benzoin propyl ether and benzoin isobutyl ether; acetophenones, such as acetophenone, 2,2-dimethoxy-2-phenyl acetophenone, 2,2-diethoxy-2-phenyl acetophenone, 1,1-dicholroacetophenone, 2-hydroxy-2-methyl-1-phenylpropane-1-one, diethoxy acetophenone, 1-hydroxycyclohexyl phenyl ketone and 2-methyl-1-[4-(methylthio)phenyl]-2-morpholino-propane-1-one; anthraquinones such as 2-ethyl anthraquinone, 2-tertiary-butyl anthraquinone, 2-chloroanthraquinone and 2-amyl anthraquinone; thioxanthones such as 2,4-diethyl thioxanthone, 2-isopropyl thioxanthone and 2-chlorothioxanthone; ketals such as acetophenone dimethyl ketal and benzyl dimethyl ketal; benzophenones such as benzophenone and 4,4-bismethyl aminobenzophenone; and 2,4,6-trimethyl benzoyl diphenyl phosphine oxide.

These may be used alone, or two or more kinds of these may be used as a mixture, and these may be used in combination with an accelerator like a tertiary amine such as triethanol amine and methyl diethanol amine, and benzoic acid derivatives, such as N,N-dimethyl aminobenzoic acid ethylester and N,N-dimethyl aminobenzoic acid isoamyl ester.

The content of the photopolymerization initiator (C) is preferably set to 0.5 to 20 parts, preferably, 2 to 15 parts, more preferably, 2 to 5 parts, with respect to the total mass 100 parts of the (A) component and (B) component.

In addition to the above-mentioned components, the present invention preferably contains a heat curing component (D) as a curing-use component, and by containing this, it is possible to form a printed circuit-board-use material that is excellent in soldering heat resistance and electric properties. With respect to the heat curing component (D) to be used in the present invention, although not particularly limited as long as it has a functional group that is subjected to a heat-curing process together with the oligomer (A) in its molecule, examples thereof include: epoxy resins, melamine compounds, urea compounds, oxazoline compounds and phenol compounds. With respect to the epoxy resin, specific examples thereof include glycidyl ethers, such as bisphenol A-type epoxy resins, bisphenol F-type epoxy resins, phenol-novolak-type epoxy resins, cresol-novolak-type epoxy resins, trisphenol methane-type epoxy resins, brominated epoxy resins, bixylenol-type epoxy resins and biphenol-type epoxy resins; alicyclic epoxy resins, such as 3,4-epoxy-6-methylcyclohexyl methyl-3,4-epoxy-6-methylcyclohexane carboxylate, 3, 4-epoxycyclohexyl methyl-3, 4-epoxycyclohexane carboxylate, 1-epoxyethyl-3,4- epoxycyclohexane; glycidyl esters, such as diglycidyl phthalic acid esters, diglycidyl tetrahydrophthalic acid esters and glycidyl dimer acid esters; and heterocyclic epoxy resins. With respect to the melamine compound, examples thereof include melamine and a melamine resin that is a polycondensation product between melamine and formalin. With respect to the urea compound, examples thereof include urea and a urea resin that is a polycondensation product between urea and formalin. With respect to the oxazoline compound, examples thereof include 2-oxazoline, 2-methyl-2-oxazoline, 2-phenyl-2-oxazoline, 2,5-dimethyl-2-oxazoline, 5-methyl-2-phenyl-2-oxazoline and 2,4-diphenyl oxazoline. With respect to the phenol compound, examples thereof include phenol, cresol, xylenol, catechol, resorcin, hydroquinone, pyrogallol and resol.

Among these heat curing components (D), epoxy resins are preferably used because these resins are particularly superior in reactivity with the carboxyl group in the (A) component, and also has good adhesion to copper. In particular, epoxy resins having a fusing point of 50°C or more are desirably used, because these make it possible to form a photopolymerization coat film that is free from tacks after the drying process.

With respect to the preferable range of the used amount of the above-mentioned heat curing component (D), it is set to a rate at which the functional group of the heat curing component (D) forms 0.2 to 3.0 equivalents per carboxyl group in the above-mentioned (A) component. In particular, the rate is preferably set to a rate at which the component forms 1.0 to 1.5 so as to provide superior soldering heat resistance and electric properties when formed into a printed circuit board.

Moreover, in the case when an epoxy resin is used as the above-mentioned heat curing component (D), a curing accelerator for the epoxy resin is preferably used so as to accelerate the reactionwith the carboxyl group in the above-mentioned component (A). With respect to the curing accelerator for the epoxy resin, examples thereof include: imidazole compounds such as 2-methyl imidazole, 1-cyanoethyl-2-ethyl imidazole and 1-cyanoethyl-2-undecyl imidazole; triazine derivatives such as melamine, guanamine, acetoguanamine, benzoguanamine, 2,4-diaminotriazine and 2,4-diamino-6-tolyltriazine; tertiary amines such as triethanol amine, pyridine, m-dimethyl aminophenol; and polyphenols. Furthermore, a substance that is turned into a curing accelerator when subj ected to irradiation from ultraviolet rays and the like may be used, and preferable examples thereof include 1, 4-dihydropyridine derivatives, such as 1-ethyl-3,5-dimethoxycarbonyl-4-(2-nitrophenyl)-1,4-dihydro pyridine, 1,2,6-trimethyl-3,5-dimethoxycarbonyl-4-(2-nitrophenyl)-1,4-dihydropyridine, 2,6-dimethyl-3,5-diacetyl-4-(2-nitrophenyl)-1,4-dihydropyridine and 1-carboxyethyl-3,5-dimethoxycarbonyl-4-(2-nitrophenyl)-1,4-dihydropyridine. These curing accelerators may be used alone or in combination.

Moreover, in the present invention, in addition to the above-mentioned oligomer (A), diluent (B),photopolymerization initiator (C) and heat curing component (D), various additives may be added thereto, if necessary, in order to improve various properties of the composition; and examples thereof include: fillers such as talc, barium sulfate, calcium carbonate, magnesium carbonate, barium titanate, aluminum hydroxide, aluminum oxide, silica and clay; thixotropic property applying agent such as aerosil; colorants such as phthalocyanine blue, phthalocyanine green and titanium oxide; leveling agents and antifoamers such as silicone and fluorine-based materials; and polymerization inhibitors such as hydroquinone andhydroquinone monomethyl ether.

Here, the above-mentioned (D) componentmaybepreliminarily mixed in the resin composition; however, the component is more preferably mixed therein prior to the coating process onto the printed circuit board. In this case, a main agent solution is prepared by blending one portion or the entire portion of (B) component and an epoxy curing accelerator to the (A) component serving as the main component, and a curing agent solution is prepared by blending one portion or the entire portion of (B) component to the (D) component serving as the main component, and these two solutions are preferably mixed upon application of the resin composition.

The resin composition of the present invention may be used inthefollowingmanner: for example, apolymerfilm (for example, a film made from polyethylene terephthalate, polypropylene, polyethylene or the like) is used as a supporting member, and the resin composition is applied thereon as laminated layers so that, by allowing the organic solvent (B-1) used as the diluent (B) to evaporate, a photosensitive film can be formed.

The resin composition (liquid state or film state) of the present invention is useful for an interlayer insulatingmaterial for electronic parts as well as for resist ink as solder resists for use in printed substrates, and in addition to these applications, it is also used as a sealing agent, a coating material, a coating agent, a bonding agent and the like.

The cured article of the present invention is formedby curing the above-mentioned resin composition of the present invention through irradiation of energy rays such as ultraviolet rays. The curing process through irradiation of energy rays such as ultraviolet rays maybe carriedout by using a conventionalmethod. For example, upon applying ultraviolet rays, an ultraviolet-ray generator, such as a low-pressure mercury lamp, a high-pressure mercury lamp, a super-high pressure mercury lamp, a xenon lamp and an ultraviolet-ray emitting laser (excimer laser and the like), may be used. The cured article of the resin composition of the present invention is utilized as an interlayer insulating material for use in, for example, permanent resist and build-up technique, in electric/electronic parts such as printed substrates. The film thickness of the cured article layer is preferably set in a range of 0.5 to 160µm, more preferably, 1 to 60µm.

The printed circuit board of the present invention may be obtained, for example, in the following manner: In other words, in the case when a liquid-state resin composition is used, the composition of the present invention is applied onto a printed circuit-use substrate with a thickness of 5 to 160µm, by using a screen printingmethod, a sprayingmethod, a roll coatingmethod, an electrostatic coating method, a curtain coating method and the like, and the coated film is dried at a temperature in a normal range of 60 to 110°C, preferably, 60 to 100°C, so that a coat film that is free from tacks can be formed. Thereafter, a photomask having an exposure pattern formed thereon, such as a negative-working film, is directly made in contact with the coat film (or placed over the coat film without being made in contact therewith) , and this is irradiated with ultraviolet rays with an intensity in a normal range of 10 to 2000 mJ/cm², and the unexposed portion is developed by using a developer as described below through a process, such as spraying, a shaking immersion, brushing and scrubbing. Thereafter, this is further irradiated with ultraviolet rays, if necessary, and then subjected to a heating process at a temperature in a normal range of 100 to 200°C, preferably, 140 to 180°C; thus, it is possible to provide a printed circuit board having a permanent protective film that is superior in flexibility, and satisfies various properties, such as heat resistance, solvent resistance, acid resistance, adhesion and electric properties.

With respect to the organic solvent to be used for the developing process, examples thereof include: halogens such as trichloroethane; aromatic hydrocarbons such as toluene and xylene; esters such as ethyl acetate and butyl acetate; ethers such as 1,4-dioxane and tetrahydrofran; ketones such as methylethyl ketone and methyl isobutyl ketone; lactones such as γ-butyl lactone; glycol derivatives such as butyl cerosolve acetate, carbitol acetate, diethylene glycol dimethylether and propylene glycol monomethyl ether acetate; alicyclic hydrocarbons such as cyclohexanone and cyclohexanol; and solvents such as petroleum solvents like petroleum ether and petroleum naphtha; and water, and with respect to alkali aqueous solutions, alkali aqueous solutions of potassium hydroxide, sodiumhydroxide, sodiumcarbonate, potassium carbonate, sodium phosphate, sodium silicate, ammonia, amines and the like, may be used. Moreover, with respect to the irradiation light-source used for photo-curing, for example, a low-pressure mercury lamp, a middle-pressure mercury lamp, a high-pressure mercury lamp, a super-high pressure mercury lamp, a xenon lamp or a metal halide lamp may be appropriately used. In addition to these, laser light and the like may be used as exposure-use active light.

### EXAMPLES

By way of working examples, the present invention will be explained hereinafter. However, the present invention is not limited to these examples.

### (Synthesis Example of Oligomer (A))

### Synthesis Example 1

The above-mentioned bisphenol F type epoxy resin (380 g) in which, in formula (1), X is -CH₂-, M is a hydrogen atom and the average degree of polymerization m is 6.2 (epoxy equivalent: 950g/eq, softening point: 85°C) andepichlorohydrin (925g) were dissolved in 462.5 g of dimethylsulfoxide, and to this was then added 60.9 g (1.5 moles) of 98.5% NaOH at 70°C while being stirred, in 100 minutes. After the addition, this was allowed to further react with one another at 70°C for 3 hours. After completion of the reaction, to this was added 250 g of water, and washed with water. After having been subjected to an oil-water separating process, most of dimethyl sulfoxide and excessive unreacted epichlorohydrin were distilled and collected from the oil phase under reduced pressure, and dimethyl sulfoxide was then distilled off so that the reaction product containing by-product salt was dissolved in 750 g of methylisobutylketone, and to this was further added 10 g of 30% NaOH, and allowed to react for one hour at 70°C. After completion of the reaction, this was washed with 200 g of water twice, and after having been subjected to an oil-water separating process, methylisobutylketone was distilled and collected from the oil phase so that epoxy resin (a-1) having an epoxy equivalent of 310 g/eq and a softening point of 69°C was obtained. When calculated based upon the epoxy equivalent, it was found that in the resulting epoxy resin (a-1), about 5 of 6.2 alcohol-based hydroxyl groups in the above-mentioned starting substance, bisphenol F type epoxy resin, were epoxidized. The resulting epoxy resin (a-1) (310 g), dimethylol propionic acid (20.1 g), HYCAR CTBN1300 × 13 (52.5 g) [made by B.F. Goodrich Chemical Co., Ltd.] having a molecular weight of 3500, 27% of bonded acrylonitrile and a rate of carboxyl group of 1.91/molecule, acrylic acid (43.4 g), maleimide caproic acid (44.2 g)(ratio of number of epoxy groups : total carboxyl groups = 1 : 0.98), triphenyl phosphine (2.0 g), methylhydroquinone (0.3 g) and carbitol acetate (238.4 g) were loaded, and this was allowed to react at 98°C for about 35 hours to obtain oligomer (A-[1]-1). The solid component of the reaction product was 65%, the weight-average molecular weight of the solid component was about 6500 (based upon GPC method), and the acid value of the solid component was 1.5 mgKOH/g.

### Synthesis Example 2

The oligomer (A-[1]-1)(681.1 g) obtained in synthesis example 1, tetrahydrophthalic anhydride (53.2 g), succinic anhydride (35.0 g) (number of hydroxyl groups : number of acid anhydride groups = 1 : 0.70) and carbitol acetate (52.2 g) were allowed to react with one another at 90°C for about 10 hours to obtain a reaction product (oligomer (A-[2]-1)) with a solid component of 65%, which had an acid value of the solid component of 72 mgKOH/g and a weight-average molecular weight of the solid component of about 9000 (based upon GPC method).

### Synthesis Example 3 (Synthesis example of oligomer used for comparison)

Epoxy resin (a-1) obtained in synthesis example 1 (310 g) , acrylic acid (71.3 g), triphenylphosphine (1.75 g), methylhydroquinone (0.3 g) and carbitol acetate (206.4 g) were loaded, and this was allowed to react with one another at 98°C for about 35 hours, and to this were then added tetrahydrophthalic anhydride (43.1 g), succinic anhydride (28.4 g) and carbitol acetate (38.5 g), and allowed to react with one another at 90°C for about 10 hours to obtain a reaction product with a solid component of 65%, which had an acid value of the solid component of 72 mgKOH/g and a weight-average molecular weight of the solid component of about 7000 (based upon GPC method).

### Examples 1 to 3, Comparative Examples 1 to 3

Resist compositions of the present invention were blended in accordance with blending compositions of Table 1, and dissolved and kneaded to be prepared. Next, each of the resist compositions thus prepared was applied onto a printed circuit substrate (formed by laminating an imide film with copper foil) by using a screen printing process, and dried at 80° for 20 minutes. Thereafter, anegative-workingfilmwasplacedonthissubstrate, and this was irradiated with ultraviolet rays at an accumulated dose of exposure of 600 mJ/cm² in accordance with a predetermined pattern by using an exposing machine, and then developed by using γ-butyrolactone (example 1) and an 1.0 wt% Na₂CO₃ aqueous solution (examples 2, 3 as well as comparative examples 1 to 3), and further subjected to a heat curing process at 150°C for 60 minutes to prepare a sample substrate. Each of the resulting resist compositions was evaluated with respect to photosensitive performances. In other words, with respect to the resulting sample substrate, evaluation was made on characteristics such as developability, soldering heat resistance, flexibility, resistance to thermal deterioration and resistance to electroless gold plating. The results are shown in Table 2. Here, the evaluation method and evaluation criteria are shown as follows:

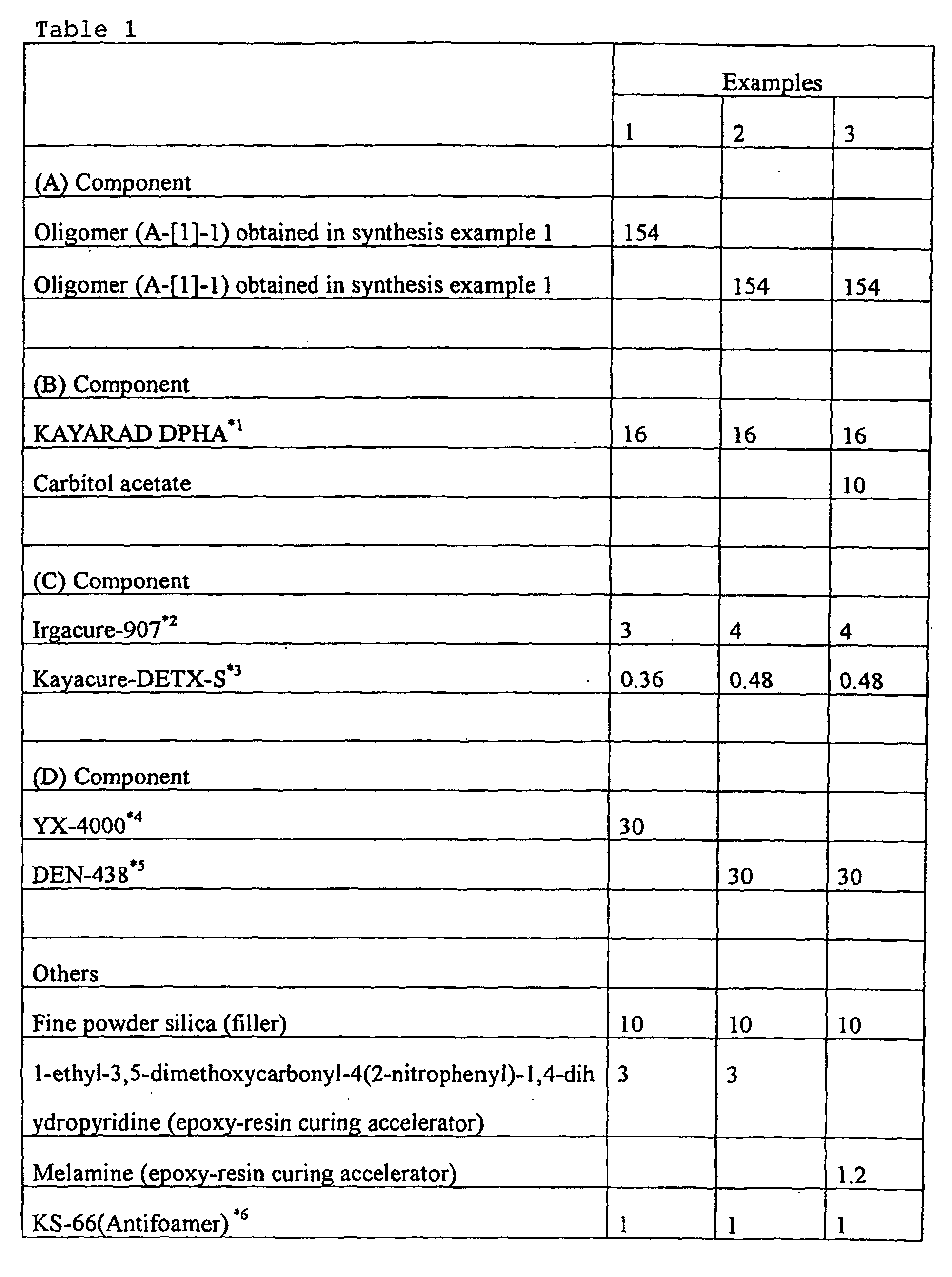

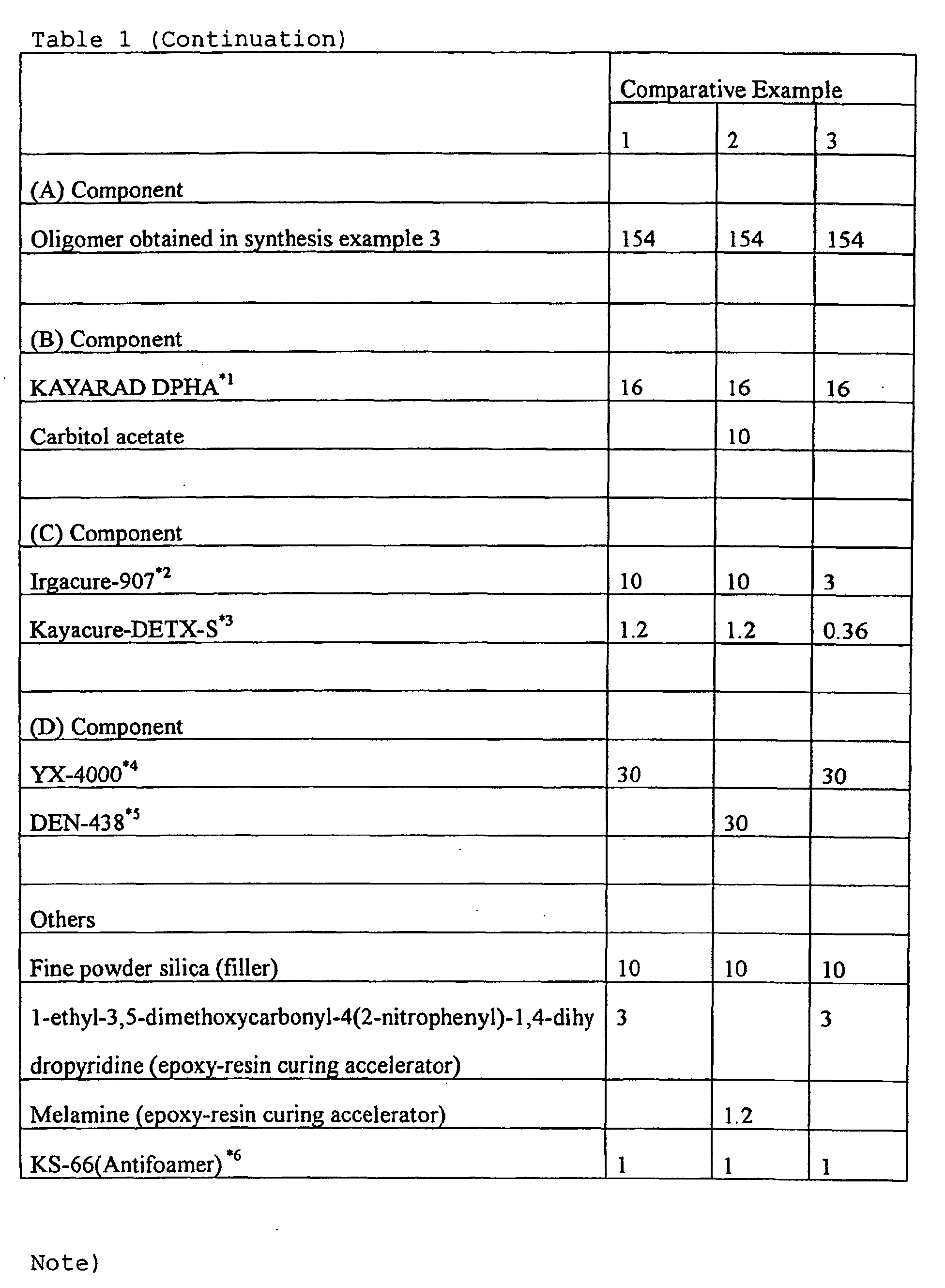

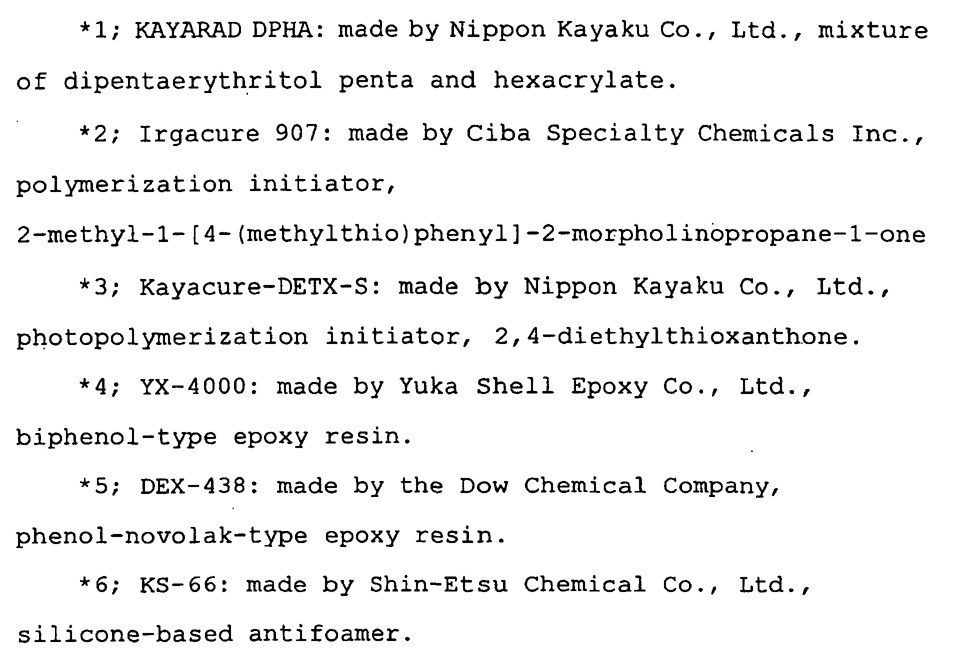

### Evaluation method and evaluation criteria

### (1) Photosensitivity

Step tablets having 21 steps (made by Stopher Co., Ltd.) were made in contact with a coat film after the drying process, and this was irradiated with ultraviolet rays having an accumulated quantity of light of 600 mJ/cm². Next, this was subjected to a developing process by using γ-butyrolactone (example 1) and a 1% sodium carbonate aqueous solution (examples 2, 3 as well as comparative examples 1 to 3) for 60 seconds under a spraying pressure of 2.0 kg/cm² ; thus, the number of steps of coat films that remained without being developedwas confirmed. Evaluation was made based upon the following criteria.
○... 6 steps or more
Δ... 4 to 5 steps
×... not more than 3 steps

### (2) Developability

The coat film was dried at 80°C for 90 minutes, and subjected to a spray developing process by using γ-butyrolactone at 30°C (example 1) and a 1% sodium carbonate aqueous solution (examples 2, 3 as well as comparative examples 1 to 3); thus, the developability thereof was evaluated.
○... No residual matters were visually observed.
Δ... Residual matters were visually observed slightly.
×... Many residual matters were visually observed.

### (3) Soldering heat resistance

A sample substrate was coated with rosin-based flux, and immersed in fused solder at 260°C for 10 seconds; then, the resulting substrate was evaluated based upon the state of the cured film when separated by a cellophane tape.
○... No abnormality was found.
×... Separation occurred.

### (4) Flexibility

The test substrate was evaluated based upon the state when entirely folded at 180 degrees.
○... No cracks.
Δ... Cracks slightly occurred.
×... Cracks occurred in the folded portion to cause a separation in the cured film.

### (5) Resistance to thermal deterioration

After having been left at 125°C for 5 days, the test substrate was evaluated based upon the state thereof when entirely folded at 180 degrees.
○... No cracks.
Δ... Cracks slightly occurred.
×... Cracks occurred in the folded portion to cause a separation in the cured film.

### (6) Resistance to electroless gold plating

After the test substrate had been gold-plated as described below, the resulting substrate was evaluatedbased upon the state of the cured film when separated by a cellophane tape (registered trademark).
○... No abnormality was found.
Δ... Separation occurred slightly.
×... No separation occurred.

### Method for electroless gold plating

A sample substrate was immersed into an acidic defating solution (20 Vol% aqueous solution of MetexL-5B made by Nippon MacDiarmid Co., Ltd.) for 3 minutes to be defatted, and then immersed into flowing water for 3 minutes, and washed. Next, the sample substrate was immersed in a 14.3 wt% aqueous solution of ammonium persulfate at room temperature for 3 minutes to be soft-etched, and this was then immersed in flowing water for 3 minutes, and washed. Next, the sample substrate was immersed in a catalyst solution (made by Meltex Co., Ltd., 10 Vol% aqueous solution of metal plate activator 350) for 7 minutes so that the catalyst was applied thereto, and this was then immersed in flowing water for 3 minutes, and washed. The sample substrate to which the catalyst had been applied was immersed in a 20 Vol% aqueous solution (PH 4.6) of nickel plating solution at 85°C for 20 minutes so that an electroless nickel plating process was carried out thereon. After having been immersed in 10 Vol% sulfate aqueous solution at room temperature for 1 minute, the sample substrate was immersed in flowing water for 30 seconds to 1 minute to be washed. Next, the sample substrate was immersed in a gold plating solution (made by Meltex Co., Ltd., solution of 15 Vol% AurolectrolessUP and 3 Vol% of potassium gold cyanide, PH 6) at 95°C for 20 minutes so that an electroless gold plating process was carried out thereon, and this was then immersed in flowing water for 3 minutes to be washed, and further immersed in hot water at 60°C for 3 minutes to be hot-water-washed. After this had been sufficiently washed, water was fully shaken off and this was dried to obtain an electroless-gold-plated sample substrate.

**Table 2**

| Items | Example | | | Comparative Example | | |
|---|---|---|---|---|---|---|
| | 1 | 2 | 3 | 1 | 2 | 3 |
| Photosensitivity | ○ | ○ | ○ | ○ | ○ | × |
| Developability | ○ | ○ | Δ | Δ | × | Δ |
| Soldering heat resistance | ○ | ○ | ○ | ○ | ○ | ○ |
| Flexibility | ○ | ○ | ○ | × | × | × |
| Resistance to thermal deterioration | ○ | ○ | ○ | × | × | × |
| Resistance to electroless gold plating | ○ | ○ | ○ | ○ | ○ | × |

As clearly shown by the contents of Table 2, the resin composition of the present invention exerts sufficient photosensitivity even when the used amount of a polymerization initiator is made smaller, is excellent in developability, and provides a cured film that is excellent in soldering heat resistance, flexibility, resistance to thermal deterioration and resistance to electroless gold plating.

### INDUSTRIAL APPLICABILITY

The present invention makes it possible to provide a resin composition which exerts sufficient curability, even when the used amount of a polymerization initiator is made smaller, is excellent in developability, provides a cured film that is excellent in flexibility, soldering heat resistance, resistance to thermal deterioration and resistance to electroless gold plating, makes it possible to carry out a developing process by using a lean alkali solution, and is suitably applied to a material for use in solder resist and interlayer insulating layers. This resin composition is particularly suitable for solder resist and interlayer insulating layers for use inprinted circuit boards, in particular, flexible printed circuit boards.

## Claims

1. A resin composition comprising:
anoligomer (A) obtainedbyallowingthefollowingcomponents (a) to (d) to react with one another:
(a) an epoxy resin having at least two epoxy groups per molecule;
(b) a compound having at least two hydroxyl groups and one carboxyl group per molecule;
(c) a carboxylated rubbery polymer; and
(d) a monobasic acid having an unsaturated group.

2. A resin composition comprising:
an oligomer (A) obtained by allowing the following compounds (a) to (e) to react with one another:
(a) an epoxy resin having at least two epoxy groups per molecule;
(b) a compound having at least two hydroxyl groups and one carboxyl group per molecule;
(c) a carboxylated rubbery polymer;
(d) a monobasic acid having an unsaturated group; and
(e) a multibasic acid anhydride.

3. The resin composition according to claim 1 or claim 2, wherein the oligomer (A) has a weight-average molecular weight in a range of 1000 to 100,000.

4. The resin composition according to any one of claims 1 to 3, wherein the oligomer (A) has an acid value in a range of 1 to 300 mgKOH/g.

5. The resin composition according to any one of claims 1 to 4, wherein the epoxy resin (a) having at least two epoxy groups per molecule is represented by the following formula (1): 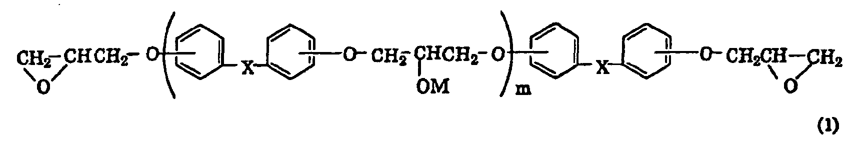 in formula (1), X is -CH₂- or -C(CH₃)₂- , m is an integer of 1 or more, and M is a hydrogen atom or a group represented by the following formula (G): 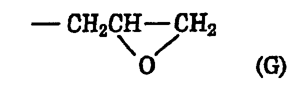 (here, in the case when m is 1, M is represented by formula (G) , and in the case when m is greater than 1, at least one of M is represented by formula (G) with the rest thereof being hydrogen atoms.)

6. The resin composition according to claim 5, wherein in formula (1), the rate of M being represented by formula (G) is in a range of 70 to 90 mole%.

7. The resin composition according to any one of claims 1 to 6, wherein the compound (b) having two hydroxyl groups and one carboxyl group per molecule is a dimethylolated compound of carboxylic acid having 2 to 6 carbon atoms.

8. The resin composition according to any one of claims 1 to 7, wherein the monobasic acid having an unsaturated group (d) is one kind or two or more kinds of compounds selected from the group consisting of (metha) acrylic acids and monobasic acids containing a maleimide group.

9. The resin composition according to claim 2, wherein the multibasic acid anhydride (e) isaphthalicanhydridederivative.

10. The resin composition according to any one of claims 1 to 9, further comprising a photo-polymerization initiator (C).

11. The resin composition according to any one of claims 1 to 10, further comprising a heat curing component (D).

12. The resin composition according to claim 11, wherein the heat curing component (D) is an epoxy resin.

13. The resin composition according to claim 12, further comprising a 1,4-dihydropyridine derivative as a curing accelerator agent for the epoxy resin.

14. The resin composition according to any one of claims 1 to 13, further comprising a diluent (B).

15. A composition, which contains the resin composition according to claim 14, and is used for a solder resist or an interlayer insulating layer for use in a printed circuit board.

16. A cured article comprising the composition according to any one of claims 1 to 15.

17. A product comprising a layer of the cured article according to claim 16.

18. The product according to claim 17, comprising a printed circuit board.
